# EUROPEAN PATENT APPLICATION

(11) **EP 3 316 305 A1**
(43) Date of publication of application: **02.05.2018**
(21) Application number: 17198648.2
(22) Date of filing: 26.10.2017
(51) Int. Cl.: H01L 27/146, H01L 27/28

(54) **ANALOG RADIATION WAVELENGTH CONVERTERS**

(30) Priority: 27.10.2016 US 201615336493
(71) Applicant: Sensors Unlimited, Inc., Princeton, NJ 08540 (US)
(72) Inventor: FUSTOS, Richard J., Princeton, NJ 08540 (US); LOESSER, Kenneth A., Milford, NJ 08848 (US)
(74) Representative: Bridge, Kerry Ann

(57) **Abstract**

A radiation wavelength converter includes a detector (101) configured to receive radiation of a first wavelength and to convert the radiation of a first wavelength to one or more electrical signals. The converter includes an integrated circuit (103) (e.g., electrically connected to the detector to receive the one or more electrical signals) configured to amplify the one or more electrical signals. The converter (100) also includes an emitter (105) (e.g., formed on or attached to the integrated circuit and configured to be electrically connected to the integrated circuit (103) to receive the one or more amplified electrical signals) configured to convert the one or more amplified electrical signals to radiation of a second wavelength.

## Description

### BACKGROUND

### 1. Field

The present disclosure relates to light signal conversion, more specifically to analog radiation wavelength converters (e.g., invisible light to visible light converters).

### 2. Description of Related Art

Thus far, every SWIR imager made has been made the same way, using a silicon-based read-out integrated circuit (ROIC) that is interfaced to a photodiode array made up of some exotic semiconductor. The job of the ROIC is to integrate, digitize, and read out the quantity of photons that hit the photodiode array. The ROIC itself draws a fair amount of power and has limits in terms of noise and dynamic range. In many applications the digitized signal is then processed by power hungry support circuitry and is sent out to a display to be turned into visible light for the user to observe. This process is wasteful, but has always been seen as necessary.

Such conventional methods and systems have generally been considered satisfactory for their intended purpose. However, there is still a need in the art for improved radiation wavelength converters. The present disclosure provides a solution for this need.

### SUMMARY

A radiation wavelength converter includes a detector configured to receive radiation of a first wavelength and to convert the radiation of a first wavelength to one or more electrical signals. The converter includes an integrated circuit (e.g., electrically connected to the detector to receive the one or more electrical signals) configured to amplify the one or more electrical signals. The converter also includes an emitter (e.g., formed on or attached to the integrated circuit and configured to be electrically connected to the integrated circuit to receive the one or more amplified electrical signals) configured to convert the one or more amplified electrical signals to radiation of a second wavelength.

The detector can include a photodiode array comprising a plurality of photodetectors that convert the radiation of the first wavelength to a plurality of electrical signals. The integrated circuit can include a separate electrical circuit for each photodetector such that the integrate circuit amplifies each electrical signal from each photodetector. The emitter can be a diode array having a plurality of radiation emitting diodes that receive the plurality of amplified electrical signals and convert the plurality of amplified electrical signals to the radiation of a second wavelength. In certain embodiments, the emitter diode array can include the same number of radiation emitting diodes as photodetectors.

The first wavelength can be an invisible wavelength. In certain embodiments, the first wavelength can be one of short wave infrared, infrared, long wave infrared, ultraviolet, or XRAY.

The second wavelength can include visible light, for example. In this regard, the radiation emitting diodes can be light emitting diodes. In certain embodiments, the light emitting diodes include organic LEDs.

In certain embodiments, a glass substrate can be disposed over the emitter and configured to pass radiation of the second wavelength. A focusing lens can be disposed in front of the detector and configured to focus radiation onto the detector.

In accordance with at least one aspect of this disclosure, an optical system can include a radiation wavelength converter as described herein. The optical system can be configured for any suitable use.

A method for converting non-visible radiation into visible radiation includes receiving non-visible radiation at a detector to convert the non-visible radiation to an electrical signal, amplifying the electrical signal, and sending the amplified electrical signal to an emitter to emit visible light from the emitter based on the electrical signal.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below with reference to certain figures, wherein:

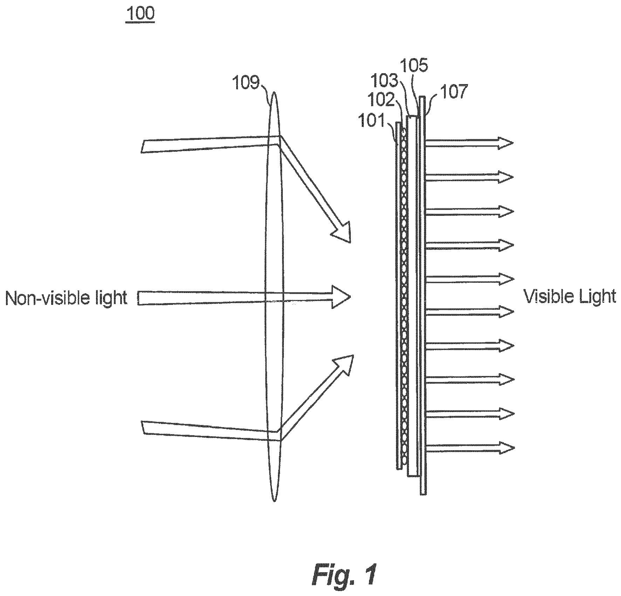

Fig. 1 is a schematic side view of an embodiment of a radiation wavelength converter in accordance with this disclosure, showing non-visible light (e.g., SWIR) being converted to visible light.

### DETAILED DESCRIPTION

Reference will now be made to the drawings wherein like reference numerals identify similar structural features or aspects of the subject disclosure. For purposes of explanation and illustration, and not limitation, an illustrative view of an embodiment of a radiation wavelength converter in accordance with the disclosure is shown in Fig. 1 and is designated generally by reference character 100. The systems and methods described herein can be used to convert a first wavelength to a second wavelength with analog circuitry and minimum power input.

Referring to Fig. 1, a radiation wavelength converter 100 includes a detector 101 configured to receive radiation of a first wavelength (e.g., non-visible light as depicted) and to convert the radiation of a first wavelength to one or more electrical signals. The detector 101 can be made of any suitable first wavelength sensitive materials (e.g., InGaAs for short wave infrared/near infrared applications, microbolometer materials for infrared, and/or materials sensitive to UV or X-ray for example).

Conversion to the one or more electrical signals can be direct or indirect as appreciated by those having ordinary skill in the art. For example, a photodiode can directly convert radiation of the first wavelength to electrical signals. However, in the case of a microbolometer for example, the incoming radiation can produce a change in the material, this change being detectable electrically, thereby creating electrical signals indirectly.

The converter 100 also includes an integrated circuit 103 electrically connected to the detector 101 to receive the one or more electrical signals and configured to amplify the one or more electrical signals. The integrated circuit 103 can include any suitable circuitry for signal amplification as appreciated by those skilled in the art in view of this disclosure. For example, the integrated circuit 103 can include a low noise receiver, an amplifier, in-pixel correction, and an output driver.

The integrated circuit 103 can be bonded to the detector 101 in any suitable manner. The integrated circuit 103 can be made of any suitable base material (e.g., silicon).

The converter 100 also includes an emitter 105 formed on or attached to the integrated circuit 103. The emitter 105 is configured to be electrically connected to the integrated circuit 103 to receive the one or more amplified electrical signals to convert the one or more amplified electrical signals to radiation of a second wavelength (e.g., visible light as depicted). The emitter 105 may emit out that back of the chip, front of the chip, or in any suitable direction.

The detector 101 can include a photodiode array comprising a plurality of photodetectors that convert the radiation of the first wavelength to a plurality of electrical signals. The integrated circuit 103 can include a separate electrical circuit for each photodetector such that the integrate circuit 103 amplifies each electrical signal from each photodetector.

The emitter 105 can be a diode array having a plurality of radiation emitting diodes that receive the plurality of amplified electrical signals and convert the plurality of amplified electrical signals to the radiation of a second wavelength. In certain embodiments, the emitter diode array can include the same number of radiation emitting diodes as photodetectors. In this regard, each photodetector can be in isolated analog electrical communication with a corresponding radiation emitting diode through the integrated circuit 103.

To achieve this, the bond layer 102 between the detector 101 and the integrated circuit 103 can be formed of individual electrically conductive pads that connect each photodetector to each discrete circuit of the integrated circuit 103. The emitter 105 can be additively built on back of integrated circuit (e.g., deposited OLED) in any suitable manner as appreciated by those having ordinary skill in the art. Pixel size can be any suitable size (e.g., roughly 5 micron from a center of a pixel to the center of another pixel).

The first wavelength can be an invisible wavelength. In certain embodiments, the first wavelength can be one of short wave infrared (SWIR), infrared (IR), long wave infrared (LWIR), ultraviolet, or XRAY. Any other suitable wavelength is contemplated herein.

The second wavelength can include visible light, for example. In this regard, the radiation emitting diodes can be light emitting diodes. In certain embodiments, the light emitting diodes include organic LEDs. Any other suitable wavelength is contemplated herein.

In certain embodiments, a glass substrate 107 can be disposed over the emitter 105 and can be configured to pass radiation of the second wavelength therethrough. A focusing lens 109 can be disposed in front of the detector 101 and can be configured to focus radiation onto the detector 101.

In certain embodiments, the converter 100 can have about a square inch of area. Any other suitable size is contemplated herein.

In accordance with at least one aspect of this disclosure, an optical system can include a radiation wavelength converter 100 as described herein. The optical system can be configured for any suitable use (e.g., synthetic vision through clouds, weapon sights, water content detectors, etc.). In accordance with at least one aspect of this disclosure, a method for converting non-visible radiation into visible radiation can include receiving non-visible radiation at a detector to convert the non-visible radiation to an electrical signal, amplifying the electrical signal, and sending the amplified electrical signal to an emitter to emit visible light from the emitter based on the electrical signal.

As described hereinabove, embodiments include a custom integrated circuit that is interfaced to a photodiode array (PDA) (e.g., made up of semiconducting material) that reacts to photons of light in the spectrum of interest. The PDA generates photocurrent as a response to light stimulus from the outside world. This photocurrent is channeled through the custom integrated circuit, where it is amplified via analog circuitry. Embodiments of the integrated circuit then use this amplified photocurrent to emit light of a different wavelength from its own photodiode array in a fashion that is directly proportional to the incoming light. This allows a direct, analog conversion from, for example, non-visible SWIR light to visible light.

Direct conversion of light eliminates the need to digitize the image in handheld or HMD applications. There is no need for an FPGA or a separate display that requires a digital signal. There is no need to digitize the signal, so a large portion of existing in-pixel circuitry is eliminated. The photodiode driver can be tuned to the specific emitter that is chosen. Embodiments can be integrated with any other suitable existing systems and technology.

Embodiments can be used in reverse, wherein the emitter 105 can receive radiation and the detector 101 can output another radiation. However, efficiency in conversion may be a factor, and the materials can be selected to enhance the reverse operation. Embodiments are a low cost direct replacement for handheld imagers or head-mounted displays, for example. Such imaging systems can be used by fire fighters, pilots, law enforcement, hobbyists.

The methods and systems of the present disclosure, as described above and shown in the drawings, provide for radiation wavelength converters with superior properties. While the apparatus and methods of the subject disclosure have been shown and described with reference to embodiments, those skilled in the art will readily appreciate that changes and/or modifications may be made thereto without departing from the spirit and scope of the subject disclosure.

## Claims

1. A radiation wavelength converter (100), comprising:
a detector (101) configured to receive radiation of a first wavelength and to convert the radiation of a first wavelength to one or more electrical signals;
an integrated circuit (103) configured to amplify the one or more electrical signals; and
an emitter (105) configured to convert the one or more amplified electrical signals to radiation of a second wavelength.

2. The radiation converter of claim 1, wherein the detector (101) includes a photodiode array comprising a plurality of photodetectors that convert the radiation of the first wavelength to a plurality of electrical signals.

3. The radiation converter of claim 2, wherein the integrated circuit (103) includes a separate electrical circuit for each photodetector such that the integrated circuit (103) amplifies each electrical signal from each photodetector.

4. The radiation converter of claim 3, wherein the emitter (105) is a diode array having a plurality of radiation emitting diodes that receive the plurality of amplified electrical signals and convert the plurality of amplified electrical signals to the radiation of a second wavelength.

5. The radiation converter of any preceding claim, wherein the first wavelength is outside the visible range.

6. The radiation converter of claim 5, wherein the first wavelength is one of short wave infrared, infrared, long wave infrared, ultraviolet, or XRAY.

7. The radiation converter of claim 4, wherein the second wavelength is within the visible range.

8. The radiation converter of claim 7, wherein the radiation emitting diodes are light emitting diodes.

9. The radiation converter of claim 8, wherein the light emitting diodes include organic LEDs.

10. The radiation converter of any preceding claim, further comprising a glass substrate (107) disposed over the emitter and configured to pass radiation of the second wavelength.

11. The radiation converter of any preceding claim, further comprising a focusing lens disposed in front of the detector and configured to focus radiation onto the detector.

12. An optical system, comprising the radiation wavelength converter any preceding claim.

13. A method for converting non-visible radiation into visible radiation, comprising:
receiving non-visible radiation at a detector to convert the non-visible radiation to an electrical signal;
amplifying the electrical signal; and
sending the amplified electrical signal to an emitter to emit visible light from the emitter (105) based on the electrical signal.
